## Europäisches Patentamt

## European Patent Office

## Office européen des brevets

(19)

(11) Veröffentlichungsnummer: **0 059 802**
**B1**

(12)

# EUROPÄISCHE PATENTSCHRIFT

(45) Veröffentlichungstag der Patentschrift:
08.08.84

(21) Anmeldenummer: **81200255.8**

(22) Anmeldetag: **06.03.81**

(51) Int. Cl.³: **H 03 H 17/00**

(54) Integrierte Isolierschicht-Feldeffekttransistor-Verzögerungsschaltung für Digitalsignale und deren Verwendung in Farbfernsehempfängern.

(43) Veröffentlichungstag der Anmeldung:
**15.09.82 Patentblatt 82/37**

(45) Bekanntmachung des Hinweises auf die Patenterteilung:
**08.08.84 Patentblatt 84/32**

(84) Benannte Vertragsstaaten:
**DE FR GB IT NL**

(56) Entgegenhaltungen:
EP - A - 0 012 839
DE - A - 2 928 224
US - A - 3 277 381

INTERNATIONALE ELEKTRONISCHE RUNDSCHAU, Band 19, Nr. 9, September 1965, HEIDELBERG (DE) H. SCHÄFER "Variable Impulsverzögerung hoher Genauigkeit", Seiten 485-488
IBM TECHNICAL DISCLOSURE BULLETIN, Band 15, Nr. 10, März 1973, YORKTOWN HEIGHTS (US) T.L. JEREMIAH "Delay line oscillator", Seiten 3108-3109

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Gollinger, Wolfgang, Reinhold-Schneider-Strasse 18A, D-7803 Gundelfingen (DE)**
Erfinder: **Struthoff, Holger, Am Märzengraben 2, D-7800 Freiburg (DE)**
Erfinder: **Holzmann, Dieter, Unteres Breitle 13, D-7800 Freiburg-Munzingen (DE)**
Erfinder: **Schat, Hermanus, Habichtweg 26, D-7800 Freiburg (DE)**
Erfinder: **Elmis, Herbert, Berliner Strasse 86, D-7809 Denzlingen (DE)**
Erfinder: **Kunz, Detlev, Moosgrund 15, D-7800 Freiburg (DE)**

(74) Vertreter: **Stutzer, Gerhard, Dr. et al, Deutsche ITT Industries GmbH Patent- und Lizenzabteilung Hans-Bunte-Strasse 19 Postfach 840, D-7800 Freiburg (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf integrierte Isolierschicht-Feldeffekttransistor-Verzögerungsschaltungen für Digitalsignale mit äquidistant stufenweise einstellbarer Verzögerungszeit unter Verwendung einer aus signalflutmäßig in Serie geschalteten Invertern bestehenden Inverterkette.

Aus der DE-OS 2 928 224 ist es bekannt, daß mittels signalflutmäßig in Serie geschalteter Inverter Verzögerungsanordnungen aufgebaut werden können, die ihrerseits als Laufzeitschaltung von Ringoszillatoren dienen können, wie sie beispielsweise in der DE-OS 2 928 430 beschrieben sind. Die bekannte Inverterkette besteht aus der abwechselnden Serienschaltung eines einfachen aus Schalt- und Lasttransistor bestehenden statischen Inverters und eines durch einen Pullup-Transistor und einen Bootstrap-Kondensator erweiterten Inverters. Bei der bekannten Anordnung richtet sich die Verzögerungszeit nach der Anzahl der seriengeschalteten Inverter.

Wenn, wie von der Erfindung vorgesehen, mittels einer derartigen Inverterkette einstellbare Verzögerungszeiten möglich sein sollen, so sind die Inverterausgänge mit Signalabgriffen zu versehen und diese mittels eines Auswahlschalters anzuwählen. Je nach Lage des eingestellten Abgriffes ist dann die Verzögerungszeit einstellbar.

Die in den Ansprüchen gekennzeichnete Erfindung löst somit das Gesamtproblem, mittels einer Inverterkette äquidistant stufenweise einstellbare Verzögerungszeiten zu erreichen. Als ersten Lösungsschritt geht dabei die Erfindung von der eingangs genannten Anordnung dahingehend ab, daß sie ausschließlich statische Inverter innerhalb der Inverterkette vorsieht, und zwar eine gerade Anzahl, wobei die Ausgänge der geradzahligen Inverter zum erwähnten Auswahlschalter führen. Die kleinste einstellbare Verzögerungszeit entspricht somit der Verzögerungszeit eines Inverterpaares.

Bei der Massenfertigung derartiger integrierter Verzögerungsschaltungen treten jedoch Fertigungsschwankungen auf, die einen nicht akzeptierbaren Streubereich der Verzögerungszeit von integrierter Schaltung zu integrierter Schaltung ergeben. Auch hier will die Erfindung Abhilfe schaffen und löst somit die Unteraufgabe, trotz Fertigungsschwankungen insgesamt integrierte Verzögerungsschaltungen mit reproduzierbar gleicher Verzögerungszeit zu schaffen.

Zur Lösung dieser Aufgabe ist vorgesehen, daß während geeigneter Betriebspausen als Frequenz-Meßzeiten eine ungerade Anzahl von Invertern durch Eingangs-Ausgangs-Kopplung zu einem Ring geschaltet werden, eine digitale Meßanordnung aus der Frequenz der Selbsterregungsschwingung des Rings die Verzögerungszeit des ringgeschalteten Teils der Inverterkette bestimmt und diese Meßergebnisse entweder über die Steuerung der Gate-Spannung der Lasttransistoren die Verzögerungszeit der Inverterpaare steuert bzw. regelt oder bei konstanter Gate-Spannung die Einstellung des Auswahlschalters entsprechend ändert.

Aus der veröffentlichten Patentanmeldung EP-A-112 839 ist zwar ein Verfahren zur Angleichung der unterschiedlichen Signalverzögerungszeiten von Halbleiterchips bekannt, bei der mittels einer auf jedem Chip angeordneten Regelschaltung die dem Chip zugeführte Versorgungsspannung verändert und somit die Signalverzögerungszeit beeinflußt wird. Auch wird die tatsächliche Verzögerungszeit einer Inverterkette durch Anlegen eines Taktimpulses und Messen seiner Laufzeit in der Kette mittels eines Vergleichstaktes bestimmt, die bekannte Anordnung ist jedoch aufgrund dieser speziellen Ausgestaltung nicht dazu in der Lage, als Verzögerungsschaltung für Digitalsignale zu dienen. Sie könnte allenfalls zusätzlich zu der im Oberbegriff des Anspruchs 1 vorausgesetzten Inverterkette verwendet werden, es wären also zwei verschiedene Inverterketten erforderlich. Bei der Erfindung wird u. a. jedoch nur eine einzige Inverterkette sowohl zur Messung der Eigenverzögerungszeit als auch zur Verzögerung von Digitalsignalen benutzt.

Die durch die Erfindung erreichte Vorteile sind schon in der Lösung der Aufgabe zu sehen, da erst durch die erwähnte Messung und Regelung bzw. Einstellung in der Massenfertigung reproduzierbare Verzögerungszeiten mittels Inverterketten realisierbar sind. Darüber hinaus ergibt sich aus der Verwendung ausschließlich statischer Inverter gegenüber dem eingangs genannten Stand der Technik eine wesentliche Vereinfachung der Topologie auf dem Halbleiterkristall.

Die Erfindung wird nun anhand der Figuren der Zeichnung näher erläutert.

Fig. 1 zeigt teilweise in Form eines Blockschaltbilds ein Ausführungsbeispiel der ersten Lösungsvariante der Erfindung,

Fig. 2 zeigt wiederum teilweise in Form eines Blockschaltbilds eine Weiterbildung des Ausführungsbeispiels nach Fig. 1, und

Fig. 3 zeigt ebenfalls teilweise in Form eines Blockschaltbilds ein Ausführungsbeispiel der zweiten Lösungsvariante der Erfindung.

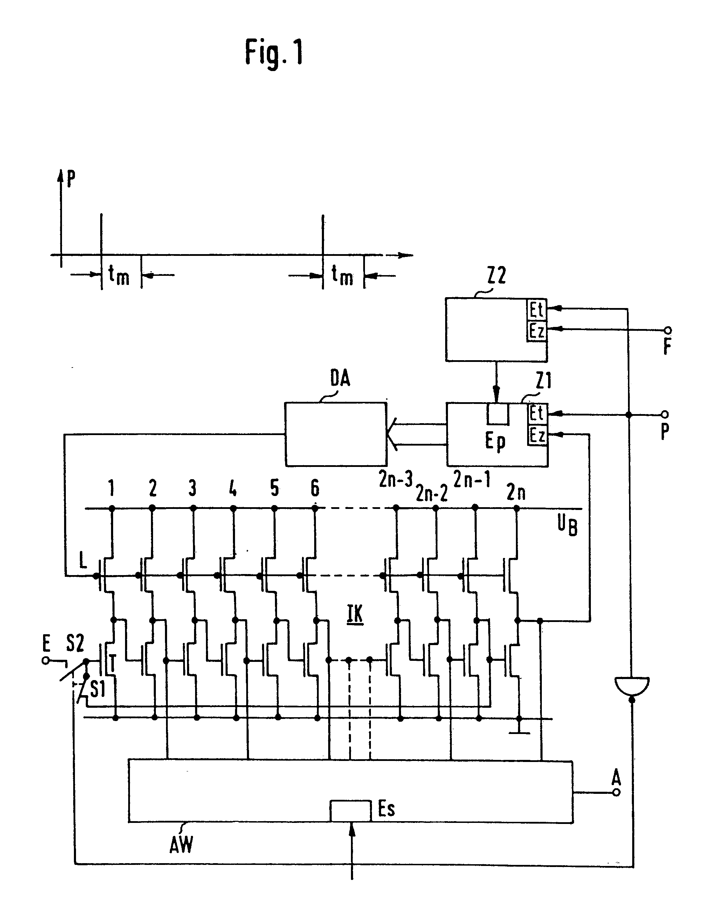

In Fig. 1 besteht die Inverterkette IK aus 2n statischen Invertern mit dem Schalttransistor T, von dem das eine Ende seines gesteuerten Strompfads am Schaltungsnullpunkt liegt, und mit dem Lasttransistor L, dessen gesteuerter Strompfad zu dem des Schalttransistors T in Serie geschaltet ist und mit seinem schalttransistor-abgewandten Ende an der Betriebsspannung $U_B$ liegt. Von den 2n Invertern sind die Inverter 1, 2, 3, 4, 5, 6, 2n-3, 2n-2, 2n-1 und 2n gezeigt. Das Gate des Schalttransistors T des ersten Inverters 1 kann über den ersten elektronischen Schalter S1 mit dem Ausgang eines ungeradzahligen Inverters verbunden werden, in Fig. 1 ist dies der vorletzte Inverter 2n-1. Ferner liegt das Gate des Schalttransistors T des ersten Inverters 1 über den zweiten elektronischen Schalter S2 am Eingang E. Die einzelnen Inverter sind dadurch signalflußmäßig in Serie geschaltet, daß der Ausgang eines vorangehenden Inverters, also der Verbindungspunkt von Schalt- und Lasttransistor T, L, mit dem Gate des nächstfolgenden Schalttransistors verbunden ist.

Die Ausgänge der geradzahligen Inverter 2, 4, 6, 2n-2, 2n sind mit den Eingängen des Eins-usn-Auswahlschalters AW verbunden, über dessen Steuereingang Es der entsprechende Abgriff angesteuert werden kann, so daß zwischen dem Eingang E und dem Ausgang A eine beliebige Zahl aus der Menge n der in Serie geschalteten Inverterpaare liegen kann. Die Einstellbarkeit des Auswahlschalters AW, der selbstverständlich ein elektronischer Auswahlschalter ist, ist durch den Pfeil am Steuereingang Es angedeutet.

Zur erwähnten Ausregelung von Fertigungsschwankungen der Verzögerungszeit ist nun nach der Erfindung vorgesehen, daß während Frequenzmeßzeiten $t_m$ eine entsprechende ungerade Anzahl von Invertern durch Eingangs-Ausgangs-Kopplung zu einem Ring geschaltet werden und daß die dadurch entstehende Selbsterregungsschwingung, deren Frequenz von der tatsächlichen Inverterverzögerungszeit abhängt, gemessen wird. Hierzu ist zunächst der erste elektronische Schalter S1 während der Frequenzmeßzeiten $t_m$ geschlossen und der zweite elektronische Schalter S2 geöffnet, so daß der Eingang E vom Gate des Schalttransistors T des ersten Inverters 1 getrennt ist. In Fig. 1 ist diese Schalterstellung der beiden elektronischen Schalter S1, S2 gezeigt.

Die Impulse der Selbsterregungsschwingung der ringgeschalteten Inverterkette werden mittels des ersten Zählers Z1 gezählt, zu welchem Zweck der Ausgang der Inverterkette IK, also der Ausgang des letzten Inverters 2n, mit dem Zähleingang Ez des Zählers Z1 verbunden ist. Seinem Starteingang Et ist das die Frequenzmeßzeiten $t_m$ festlegende Signal P zugeführt, so daß der erste Zähler Z1 jeweils bei der Vorderflanke des Meßzeitimpulses gestartet wird.

Dieses Signal P liegt auch am Starteingang Et des zweiten Zählers Z2, dessen Zähleingang Ez das Taktsignal F zugeführt wird, das bei Verwendung in Farbfernsehempfängern zweckmäßigerweise die vierfache Farbhilfsträgerfrequenz haben kann. Bei dieser Verwendung fallen dann die Frequenzmeßzeiten $t_m$ in die Bildrücklaufperioden. Der zweite Zähler Z2 zählt nun bis zu einem vorgegebenen oberen Zählerstand, dessen Ausgang mit dem Stopeingang Ep des ersten Zählers Z1 verbunden ist. Die vom zweiten Zähler Z2 bis zum erwähnten Zählerstand gezählte Anzahl von Impulsen des Taktsignals F bestimmt somit die Meßzeit $t_m$. Der bis zu diesem Zeitpunkt im ersten Zähler Z1 erreichte Zählerstand, d. h. das diesem Zählerstand entsprechende Digitalsignal wird mittels des Digital-Analog-Wandlers DA in eine Gleichspannung umgeformt, die den Gates der Lasttransistoren L der 2n Inverter zugeführt ist. Diese Spannung beeinflußt die Inverterverzögerungszeit.

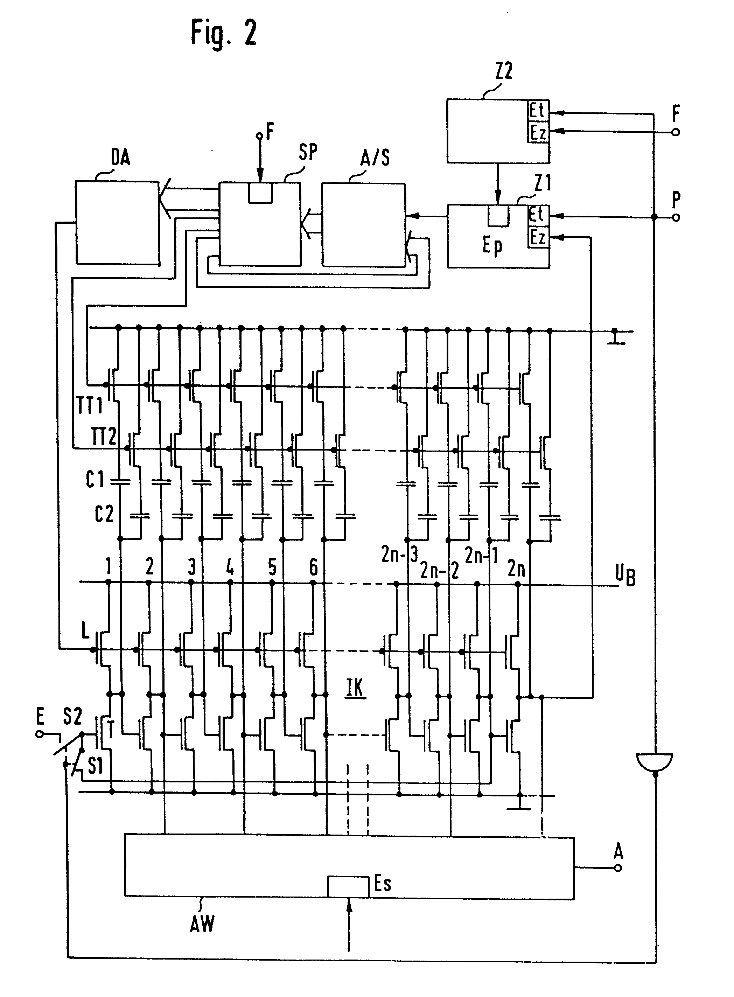

In Fig. 2 ist eine Weiterbildung des Ausführungsbeispiels nach Fig 1 gezeigt, womit ein größerer Einstellbereich der Inverterverzögerungszeit ermöglicht wird. Hierzu ist vorgesehen, daß dem Ausgang jedes Inverters Kondensatoren C1, C2 über Transfertransistoren TT1, TT2 zugeschaltet werden können, wodurch zusätzlich zu der durch die variable Gate-Spannung der Lasttransistoren L gegebenen Einstellung der Inverterverzögerungszeit eine Einstellbarkeit in grober Stufung realisiert wird.

Im einzelnen liegen die Kondensatoren C1, C2 in Serie mit dem gesteuerten Strompfad des zugeordneten Transfertransistors TT1, TT2, die einseitig am Schaltungsnullpunkt liegen und deren Gates gemeinsam vom Ausgang der beiden höchstwertigen Stellen des im Speicher SP abgespeicherten Digitalsignals angesteuert sind, während die restlichen niederwertigen Stellen dieses Digitalsignals am Eingang des Digital-Analog-Wandlers DA liegen, der wiederum die Gates der Lasttransistoren L ansteuert.

Im Ausführungsbeispiel der Fig. 2 werden die Zählergebnisse des ersten Zählers Z1, der zusammen mit dem zweiten Zähler Z2 in gleicher Weise angesteuert wird, wie in Fig. 1, zu einem Ausgangssignal verarbeitet, das oberhalb bzw. unterhalb eines Soll-Zählerstandes den einen bzw. den anderen zweier Binärsignalzustände annimmt, mit anderen Worten wird also mittels des ersten Zählers Z1 ein digitaler Schwellwert gebildet. Das diesem entsprechende Binärsignal schaltet den Addierer/Subtrahierer A/S zwischen Addieren und Subtrahieren um, so daß er entweder zum Ausgangssignal des Speichers SP, das ihm zugeführt ist, jeweils eine Einheit addiert oder davon subtrahiert. Dieses in Abhängigkeit vom Zählergebnis des ersten Zählers Z1 schrittweise veränderte Signal wird in den Speicher SP, gesteuert vom Taktsignal F, eingelesen und am Ende jeden Taktimpulses zum Ausgang durchgeschaltet. Wie bereits erwähnt, werden die höchstwertigen Stellen zur Ansteuerung der Transfertransistoren TT1, TT2 und die restlichen Stellen zum Ansteuern des Digital-Analog-Wandlers DA herangezogen.

Die mittels der Kondensatoren C1, C2 vorgenommene Grobeinstellung kann auch dadurch vorgenommen werden, daß anstatt der Kondensatoren Lasttransistoren mit von der der Lasttransistoren L abweichender Topologie zugeschaltet werden. Ferner liegt es im Rahmen der Erfindung, nicht nur zwei zusätzliche Kondensatoren, sondern im Bedarfsfall nur einen oder mehr als zwei vorzusehen.

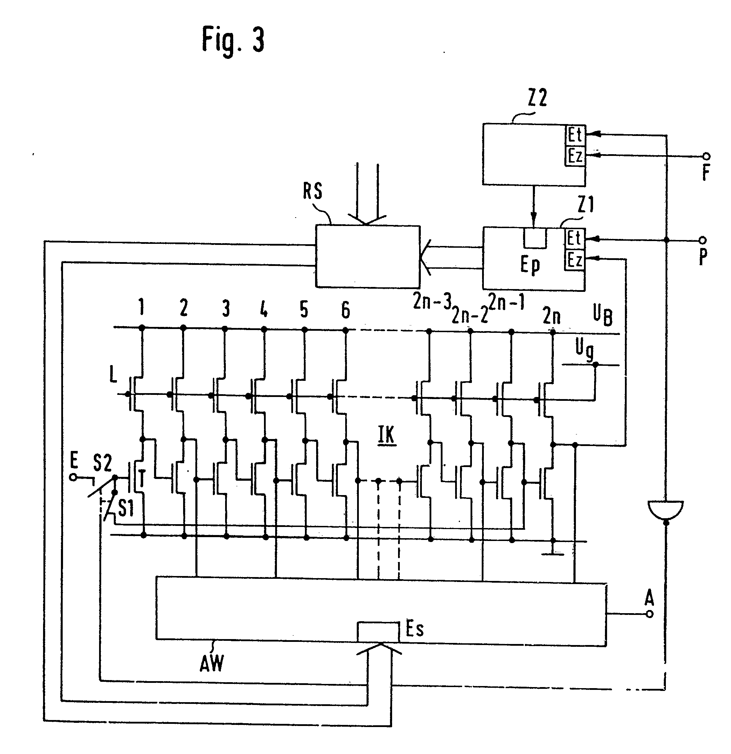

In Fig. 3 ist teilweise als Blockschaltbild ein Ausführungsbeispiel der zweiten Lösungsvariante der Erfindung gezeigt. Anstatt des Digital-Analog-Wandlers nach den Fig. 1 und 2 ist die digitale Rechenschaltung RS vorgesehen, der das Zählergebnis des ersten Zählers Z1 und der digitale Sollwert der Gesamtverzögerungszeit zugeführt sind, was durch den bandartigen Pfeil angedeutet ist. Das digitale Ausgangssignal der Rechenschaltung RS beeinflußt über den Steuereingang Es den Auswahlschalter AW, so daß bei unterschiedlichen Inverterverzögerungszeiten unterschiedliche Abgriffe zum Ausgang A durchgeschaltet werden. Die Gates der Lasttransistoren L liegen dabei an konstanter Gatespannung Ug oder sind mit den Ausgangsknoten der jeweiligen Inverter verbunden.

Das Ausführungsbeispiel der Fig. 3 ist besonders günstig, wenn der Quotient aus der Anzahl der ringgeschalteten Inverter und aus der Anzahl der mit dem zweiten Zähler Z2 gezählten Perioden des Taktsignals F gleich einer positiven oder negativen Zweierpotenz ist und wenn die Anzahl der Schalterstellungen des Auswahlschalters AW ebenfalls eine Zweierpotenz ist, da dann die digitale Rechenschaltung RS als Multiplizierer ausgeführt werden kann. In diesem Fall ist es auch zweckmäßig, die beiden Zähler Z1, Z2 als Binärzähler auszuführen, wobei dann die Zählkapazität des zweiter Zählers Z2 gleich der halben Inverteranzahl n ist.

Für die bereits erwähnte bevorzugte Verwendung der Erfindung in Farbfernsehempfängern können beispielsweise mit einer 64stufigen Inverterkette Verzögerungszeiten von etwa 70 ns in äquidistanten Schritten von 5 ns eingestellt werden.

Es kann auch zweckmäßig sein, den Ausgang eines beliebigen geradzahligen Inverters 2, 4 . . . 2n über einen Zusatzinverter mit dem Eingang der Inverterkette IK während der Frequenzmeßzeiten $t_m$ zu verbinden.

## Patentansprüche

1. Integrierte Isolierschicht-Feldeffekttransistor-Verzögerungsschaltung für Digitalsignale mit äquidistant stufenweise einstellbarer Verzögerungszeit unter Verwendung einer aus signalflußmäßig in Serie geschalteten Invertern (1 . . . 2n) bestehenden Inverterkette (IK), gekennzeichnet durch folgende Merkmale:

— die Inverterkette (IK) besteht ausschließlich aus einer geraden Anzahl (2n) statischer Inverter identischer Topologie,
— die Ausgänge der geradzahligen Inverter (2, 4 . . . 2n) sind über einen Ein-Aus-n-Auswahlschalter (AW) mit dem Signalausgang (A) verbunden,
— zur Messung und Regelung der Verzögerungszeit der Inverterkette (IK) während bestimmter Freuqenz-Meßzeiten ($t_m$) die Betriebspausen der Verzögerung sind, ist eine ungerade Anzahl von Invertern durch Eingangs-Ausgangs-Kopplung zu einem Ring geschaltet,
— eine digitale Meßanordnung bestimmt aus der Frequenz der Selbsterregungsschwingung des Rings die Verzögerungszeit des ringgeschalteten Teils der Inverterkette (IK),
— entweder steuert das Ausgangssignal der Meßanordnung nach Digital-Analog-Wandlung die Gates der Lasttransistoren (L) an, oder
— der Ausgang der Meßanordnung liegt bei konstanter Gatespannung (Ug) der Lasttransistoren (L) am ersten Parallel-Eingang einer digitalen Rechenschaltung (RS), deren zweitem Perallel-Eingang der digitale Sollwert der Gesamtverzögerungszeit der Inverterkette (IK) zugeführt ist und deren Parallel-Ausgang mit dem Parallel-Eingang (Es) des Auswahlschalters (AW) verbunden ist.

2. Verzögerungsschaltung nach Anspruch 1, gekennzeichnet durch folgende Merkmale:

— der Ausgang eines beliebigen ungeradzahligen Inverters (1, 3 . . . 2n-1) ist über einen ersten elektronischen Schalter (S1) mit dem Eingang der Inverterkette (IK) verbunden, deren Ausgang am Eingang der Meßanordnung liegt,
— das zu verzögernde Signal ist dem Eingang der Inverterkette (IK) über einen zweiten elektronischen Schalter (S2) zugeführt, und
— der erste elektronische Schalter (S1) ist lediglich während der Frequenzmeßzeiten ($t_m$) geschlossen, in denen der zweite elektronische Schalter (S2) geöffnet ist, wohingegen dieser außerhalb der Frequenzmeßzeiten ($t_m$) geschlossen ist.

3. Abwandlung der Verzögerungsschaltung nach Anspruch 2, dadurch gekennzeichnet, daß der Ausgang eines beliebigen geradzahligen Inverters (2, 4 . . . 2n) über einen Zusatzinverter mit dem Eingang der Inverterkette (IK) verbunden ist.

4. Verzögerungsschaltung nach Anspruch 2 oder 3, gekennzeichnet durch folgende Ausbildung der Meßanordnung:

— der Zähleingang (Ez) eines zu Beginn der Freqenzmeßzeiten ($t_m$) gestarteten ersten Zählers (Z1) ist mit dem Ausgang der Inverterkette (IK) verbunden,
— dem Zähleingang (Ez) eines zu Beginn der Frequenzmeßzeiten ($t_m$) gestarteten zweiten Zählers (Z2) ist ein frequenzkonstantes Taktsignal zugeführt,
— der Stop-Eingang (Ep) des ersten Zählers (Z1) ist mit einem der oberen Zählerstandausgänge des zweiten Zählers (Z2) verbunden, und
— der Parallel-Ausgang des ersten Zählers (Z1) liegt am Eingang eines Digital-Analog-Wandlers (DA).

5. Abwandlung der Verzögerungsschaltung nach Anspruch 4, gekennzeichnet durch folgende Merkmale:

— das Ausgangssignal des ersten Zählers hat oberhalb bzw. unterhalb eines Soll-Zählerstandes den einen bzw. den anderen von zwei Binärsignalzuständen und liegt am Addier/Subtrahier-Bedingungseingang eines Addierer/Subtrahierers (A/S),

— der Ausgang des Addierer/Subtrahierers (A/S) liegt am Eingang eines Speichers (SP), dessen Übernahmeeingang das Taktsignal (F) zugeführt ist,

— der (die) Ausgang (Ausgänge) mindestens einer der höchstwertigen Stellen des Speichers (SP) ist mit den Gates von jedem Inverter (1 ... 2n) zugeordneten Transfertransistoren (TT1, TT2) verbunden, deren gesteuerter Strompfad einerseits am Schaltungsnullpunkt und andererseits über einen Kondensator (C1, C2) mit dem Eingang des Inverters verbunden ist, und

— die Ausgänge der restlichen niederwertigen Stellen des Speichers (SP) liegen am Eingang des Digital-Analog-Wandlers (DA).

6. Verzögerungsschaltung nach einem der Ansprüche 1 bis 4, mit einer digitalen Rechenschaltung (RS), wobei der Quotient aus der Anzahl der ringgeschalteten Inverter und aus der Anzahl der mit dem zweiten Zähler (Z2) gezählten Perioden des Taktsignals (F) gleich einer positiven oder negativen Zweierpotenz und die Anzahl der Schalterstellungen des Auswahlschalters (AW) ebenfalls eine Zweierpotenz ist, dadurch gekennzeichnet, daß die digitale Rechenschaltung (RS) ein Multiplizierer ist.

7. Verzögerungsschaltung nach Anspruch 6, dadurch gekennzeichnet, daß der erste und der zweite Zähler (Z1, Z2) Binärzähler sind und daß die Zählkapazität des zweiten Zählers (Z2) gleich der halben Inverteranzahl (n) ist.

8. Verwendung der Verzögerungsschaltung nach einem der Ansprüche 1 bis 7 in Farbfernsehempfängern, gekennzeichnet durch folgende Merkmale:

— das zu verzögernde Signal besteht aus von den gesendeten Horizontal-Synchronimpulsen abgeleiteten Impulsen,

— die Frequenzmeßeinheit ($t_m$) fällt in die Bildrücklaufperiode, und

— das Taktsignal (F) hat die vierfache Farbhilfsträgerfrequenz.

**Claims**

1. Metal-oxide semiconductor field-effect transistor integrated delay circuit for digital signals whereby a time delay adjustable in equidistant steps can be produced using an inverter chain (IK) consisting of inverters (1 ... 2n) connected in cascade, characterized by the following features:

— The inverter chain (IK) consists exclusively of an even number (2n) of static inverters of identical topology;

— the outputs of the even-numbered inverters (2, 4 ... 2n) are connected to the signal output (A) via a 1-out-n-selector switch (AW);

— to measure and control the time delay introduced by the inverter chain (IK) during five frequency-measuring periods ($t_m$) which are intermissions in the delay, and odd number of inverters is connected to form a ring by directly coupling the output of the last odd-numbered inverter to the input of the first;

— a digital measuring arrangement determines the time delay introduced by the ring-connected portion of the inverter chain (IK) from the frequency of the self-excited oscillation of the ring, and

— either the output signal of the measuring arrangement drives the gates of the load transistors (L) after digital-to-analog conversion, or

— at a fixed gate voltage (Ug) of the load transistors (L), the output of the measuring arrangement is connected to the first parallel input of a digital computing circuit (RS) whose second parallel input is fed with the set digital value of the total time delay of the inverter chain (IK) and whose parallel output is connected to the parallel input (Es) of the selector switch (AW).

2. A delay circuit as claimed in claim 1, characterized by the following features:

— the output of any of the odd-numbered inverters (1, 3 ... 2n-1) is connected via a first electronic switch (S1) to the input of the inverter chain (K), whose output is coupled ot the input of the measuring arrangement,

— the signal to be delayed is applied to the input of the inverter chain (IK) via a second electronic switch (S2), and

— the first electronic switch (S1) is closed only during the frequency-measuring periods ($t_m$), while the second electronic switch (S2) is open during the frequency-measuring periods ($t_m$) but otherwise closed.

3. Modification of the delay circuit claimed in claim 2, characterized in that the output of any of the even-numbered inverters (2, 4 ... 2n) is connected to the input of the inverter chain (IK) via an additional inverter.

4. A delay circuit as claimed in claim 2 or 3, characterized by the following design of the measuring arrangement:

— The count input (Ez) of a first counter (Z1) started at the beginning of the frequency-measuring periods ($t_m$) is connected to the ouput of the inverter chain (IK);

— a clock signal of constant frequency is applied to the count input (Ez) of a second counter (Z2) started at the beginning of the frequency-measuring periods ($t_m$);

— the stop input (Ep) of the first counter (Z1) is connected to one of the upper count outputs of the second counter (Z2), and

— the parallel output of the first counter (Z1) is coupled to the input of a digital-to-analog converter (DA).

5. A modification of the delay circuit claimed in claim 4, characterized by the following features:

— The output signal of the first counter has one or the other of two binary states above or below a set count, respectively, and is applied to the add/subtract enable input of an adder-subtracter (A/S);

— the output of the adder-subtracter (A/S) is connected to the input of a memory (SP) whose enable input is fed with the clock signal (F);

— the output(s) for at least one of the most significant bits of the memory (SP) is (are) connected to the gates of transfer transistors (TT1, TT2) associated with each inverter (1 ... 2n) and having one end of their controlled current paths grounded, while the other end is connected to the input of the inverter via a capictor (C1, C2), and

— the outputs for the remaining bits of the memory (SP) are coupled to the input of the digital-to-analog converter (DA).

6. A delay circuit as claimed in any one of claims 1 to 4, comprising a digital computing circuit (RS), wherein the quotient of the number of ring-connected inverters and the number of periods of the clock-signal (F) counted by the second counter (Z2) is equal to a positive or negative power of two, and wherein the number of positions of the selector switch (AW) is also a power of two, characterized in that the digital computing circuit (RS) is a multiplier.

7. A delay circuit as claimed in claim 6, characterized in that the first counter (Z1) and the second counter (Z2) are binary counters, and that the capacity of the second counter (Z2) is equal to half the number (n) of inverters.

8. Use of the delay circuit claimed in any one of claims 1 to 7 in colortelevision receivers, characterized by the following featuers:

— The signal to be delayed consists of pulses derived from the transmitted horizontal synchronizing pulses;

— the frequency-measuring period ($t_m$) falls within the trace interval, and

— the clock signal (F) has four times the chrominance-subcarrier frequency.

**Revendications**

1. Circuit à retard intégré à transistors à effet de champ à grille isolée, pour signaux numériques, dont le temps de retard est réglable par échelons équidistants, comprenant une chaîne (IK) d'inverseures constituée d'inverseurs (1 ... 2n) branchés en série du point de vue du flux de signaux, caractérisé en ce que:

— la chaîne d'inverseurs (IK) est constituée exclusivement d'un nombre pair (2n) d'inverseurs statiques ayant la même topologie;

— les sorties des inverseurs à numéros d'ordre pairs (2, 4 ... 2n) sont reliées à la sortie de signal (A) par l'intermédiaire d'un sélecteur (AW) du type »un parmi n«;

— pour la mesure et la régulation du temps de retard de la chaîne d'inverseurs (IK), pendant des temps de mesure de fréquence ($t_m$) qui sont des arrêzets du retardement, un nombre impair d'inverseurs est branché en anneau par couplage entrée-sortie;

— un agencement de mesure numérique détermine, à partir de la fréquence de l'oscillation d'auto-excitation de l'anneau, le temps de retard de la partie de la chaîne d'inverseurs (IK) branchée en anneau;

— le signal de sortie de l'agencement de mesure attaque les grilles des transistors de charge (L) après conversion numérique/analogique, ou

— la sortie de l'agencement de mesure est appliquée, alors, que le tension (Ug) des grilles des transistors de charge (L) est constante, à la première entrée parallèle d'un circuit de calcul numérique (RS) dont la deuxième entrée parallèle reçoit la valeur de consigne numérique du temps de retard total de la chaîne d'inverseurs (IK), et dont la sortie parallèle est reliée à l'entrée parallèle (Es) du sélecteur (AW).

2. Circuit selon la revendication 1, caractérisé en ce que:

— la sortie d'un inverseur ayant un numéro d'ordre impair quelconque (1, 3 ... 2n-1) est reliée, par un premier interrupteur électronique (S1) à l'entrée de la chaîne d'inverseurs (IK) dont la sortie est appliquée à l'entrée de l'agencement de mesure;

— le signal à retarder est envoyé à l'entrée de la chaîne d'inverseurs (IK) par l'intermédiaire d'un deuxième interrupteur électronique (S2); et

— le premier interrupteur électronique (S1) n'est fermé que pendant les temps de mesure ($t_m$) au cours desquels le deuxième interrupteur électronique (S2) est ouvert, tandis que ce dernier est fermé en dehors des temps de mesure ($t_m$).

3. Variante du circuit selon la revendication 2, caractérisée en ce que la sortie d'un inverseur ayant un numéro d'ordre pair quelconque (2, 4 ... 2n) est reliée à l'entrée de la chaîne d'inverseurs (IK) par l'intermédiaire d'un inverseur supplémentaire.

4. Circuit selon la revendication 2 ou 3, caractérisé par la conception suivante de l'agencement de mesure:

— l'entrée de comptage (Ez) d'un premier compteur (Z1) démarré au début des temps

($t_m$) de mesure de fréquence est reliée à la sortie de la chaîne d'inverseurs (IK);
- un signal d'horloge à fréquence constante est envoyé à l'entrée de comptage ($E_z$) d'un deuxième compteur (Z2) démarré au commencement des temps ($t_m$) de mesure de fréquence;
- l'entrée d'arrêt ($E_p$) du premier compteur (Z1) est reliée à l'une des sorties de niveau de comptage supérieures du deuxième compteur (Z2); et
- la sortie parallèle du premier compteur (Z1) est appliquée à l'entrée d'un convertisseur numérique/analogique (DA).

5. Variante du circuit selon la revendication 4, caractérisée en ce que:

- le signal de sortie du premier compteur possède l'un ou l'autre de deux états binaires selon qu'il est supérieur ou inférieur à une valeur de consigne du niveau de comptage, et il est appliqué à l'entrée de commande de modalité »additionneur« ou »soustracteur« d'un additionneur/soustracteur (A/S);
- la sortie de l'additionneur/soustracteur (A/S) est appliquée à l'entrée d'une mémoire (SP) dont l'entrée de commande de prise-en-charge reçoit le signal d'horloge (F);
- la ou les sortie(s) d'au moins l'un des emplacements numériques à plus forts poids de la mémoire (SP) sont reliées aux grilles de transistore de transfert (TT1, TT2) qui sont associés à chaque inverseur (1 ... 2n) et dont le trajet de conduction commandé est relié d'une part au point zéro du circuit et d'autre part, par l'intermédiaire d'un condensateur (C1, C2), à l'entrée de l'inverseur; et
- les sorties des autres emplacements numériques de la mémoire (SP), qui ont un moindre poids, sont appliquées à l'entrée du convertisseur numérique/analogique (DA).

6. Circuit de retard selon l'une quelconque des revendications 1 à 4, avec un circuit de calcul numérique (RS), le quotient du nombre des inverseurs branchés en anneau et du nombre des périodes du signal d'horloge (F) comptées avec le deuxième compteur (Z2) étant égal à une puissance de deux positive ou négative, et le nombre des positions de sélection du sélecteur (AW) étant également une puissance de deux, caractérisé en ce que le circuit de calcul numérique (RS) est un multiplicateur.

7. Circuit selon la revendication 6, caractérisé en ce que le premier et le deuxième compteurs (Z1, Z2) sont des compteurs binaires, et en ce que la capacité de comptage du deuxième compteur (Z2) est égale à la moitié (n) du nombre des inverseurs.

8. Utilisation du circuit selon l'une quelconque des revendications 1 à 7, dans des récepteurs de télévision en couleurs, caractérisé en ce que:

- le signal à retarder est constitué par des impulsions tirées des impulsions de synchronisation horizontale émises;
- le temps ($t_m$) de mesure de fréquence tombe dans la période de retour d'image; et
- la fréquence (F) du signal d'horloge est quadruple de celle de la sous-porteuse de chrominance.

# Fig.1

# Fig. 2

# Fig. 3